# EUROPÄISCHE PATENTSCHRIFT

(11) **EP 3 036 242 B1**
(45) Veröffentlichungstag und Bekanntmachung des Hinweises auf die Patenterteilung: **17.04.2019**
(21) Anmeldenummer: 14752341.9
(22) Anmeldetag: 18.08.2014
(51) Int. Cl.: C07F 5/00, B01J 19/12

(54) **VERFAHREN ZUR HERSTELLUNG VON ALKYLINDIUM-VERBINDUNGEN UND DEREN VERWENDUNG**
METHOD FOR PRODUCING ALKYL-INDIUM COMPOUNDS AND THE USE THEREOF
PROCÉDÉ DE PRODUCTION DE COMPOSÉS ALKYLINDIUM ET UTILISATION DESDITS COMPOSÉS

(30) Priorität: 22.08.2013 DE 102013216637; 01.07.2014 DE 102014109228
(43) Veröffentlichungstag der Anmeldung: 29.06.2016
(73) Patentinhaber: Umicore AG & Co. KG, 63457 Hanau-Wolfgang (DE)
(72) Erfinder: SUNDERMEYER, Joerg, 35041 Marburg (DE); FREY, Annika, 63457 Hanau (DE); SCHORN, Wolf, 76337 Waldbronn (DE); GROSSE-HAGENBROCK, David, 35037 Marburg (DE); KARCH, Ralf, 63801 Kleinostheim (DE); RIVAS-NASS, Andreas, 64625 Bensheim (DE); WOERNER, Eileen, 61130 Nidderau (DE); DOPPIU, Angelino, 63500 Seligenstadt (DE)
(74) Vertreter: Clauswitz, Kai-Uwe Wolfram
(86) Internationale Anmeldenummer: PCT/EP2014/067546
(87) Internationale Veröffentlichungsnummer: WO 2015/024893

(56) Entgegenhaltungen:
- KR-B1- 101 221 861

## Beschreibung

Gegenstand der Erfindung ist ein Verfahren zur Herstellung von Dialkylindiumchlorid gekennzeichnet durch die allgemeine Formel R₂InCl (nachfolgend auch als Verbindung (A) bezeichnet) in hoher Ausbeute sowie mit hoher Selektivität und Reinheit.

Das erfindungsgemäß hergestellte Dialkylindiumchlorid eignet sich, auch aufgrund der hohen Reinheit und Ausbeute, besonders zur bedarfsgerechten Herstellung Indium-haltiger Präkursoren, bevorzugt solche der allgemeinen Formel R₃In (nachfolgend auch als Verbindung (B) bezeichnet) oder R₂InR' (nachfolgend auch als Verbindung (C) bezeichnet). Die mit hoher Ausbeute und in hoher Reinheit aus Verbindung (A) erhältlichen Indium-haltigen Präkursoren sind aufgrund der hohen Reinheit besonders geeignet für die metallorganische chemische Gasphasenabscheidung (MOCVD; metal organic chemical vapour deposition) oder die metallorganische Gasphasenepitaxie (MOVPE; metal organic chemical vapor phase epitaxy).

Sofern gemäß dieser Erfindung der Begriff "Verfahren" verwendet wird, ist damit immer das Verfahren zur Herstellung der Verbindung (A) und das darauf aufsetzende optionale Verfahren zur Herstellung Indium-haltiger Präkursoren, vorzugsweise der Verbindungen (B) oder (C), gemeint.

### Stand der Technik

Im Stand der Technik sind verschiedene Verfahren zur Herstellung von Verbindungen, die üblicherweise als metallorganische Präkursoren für MOCVD-Prozesse eingesetzt werden, beziehungsweise deren Vorstufen, nachfolgend vereinfacht als "Präkursor-Vorstufe" bezeichnet, beschrieben.

"Präkursor-Vorstufen" sind im Sinne dieser Erfindung solche, die durch weitere Reaktionsschritte zu den eigentlichen metallorganischen Präkursoren umgesetzt werden können, die dann unmittelbar in MOCVD- oder MOVPE-Prozessen eingesetzt werden können (kurz als "Präkursoren" oder "Indium-haltige Präkursoren" bezeichnet). Dabei ist es vorteilhaft, solche Präkursor-Vorstufen bereitzustellen beziehungsweise Präkursoren über solche Präkursor-Vorstufen herzustellen, die selbst mit hoher Selektivität und Ausbeute erhältlich sind. Zudem kann es sehr vorteilhaft sein, Präkursor-Vorstufen bereitzustellen, die einfach und mit hoher Reinheit herstellbar und gegebenenfalls isolierbar und ausreichend lagerstabil sind, um eine bedarfsgerechte und möglichst schnelle Herstellung von hochreinen Präkursoren für MOCVD- oder MOVPE-Prozesse zu ermöglichen. Die MOCVD- oder MOVPE-Prozesse werden insbesondere bei der Herstellung von Filmen für optoelektronische Anwendungen wie Solarzellen oder LEDs eingesetzt, was üblicherweise höchste Reinheit des jeweils verwendeten Präkursors, sowie die Abwesenheit beziehungsweise das Vorhandensein nur sehr geringer Anteile an sauerstoffhaltigen Verunreinigungen erfordert.

So sind verschiedene Verfahren zur Herstellung beispielsweise von Indium-haltigen, Gallium-haltigen oder auch Aluminium-haltigen Präkursoren oder entsprechenden Präkursor-Vorstufen bekannt. Die jeweiligen Verfahrensbedingungen sind allerdings nicht zwingend beziehungsweise nicht unverändert übertragbar. Es ist zu berücksichtigen, dass die Elemente Aluminium, Gallium und Indium bereits ein unterschiedliches chemisches Verhalten zeigen, woraus sich regelmäßig der Bedarf einer jeweils angepassten, besonderen Verfahrensführung bei Herstellung jeweiliger Präkursoren ergibt.

Im Stand der Technik bekannte Verfahren zur Herstellung von Indium-haltigen Präkursoren beziehungsweise Präkursor-Vorstufen stoßen oft auf erhebliche Schwierigkeiten, wenn es um die Herstellung in der für übliche Verwendungen erforderlichen Reinheit und Menge geht. So können die elektrischen Eigenschaften der aus Indium-haltigen Präkursoren über MOCVD oder MOVPE hergestellten Halbleiterschichten durch Verunreinigungen in den Präkursoren oder Präkursor-Vorstufen erheblich nachteilig beeinträchtigt werden. Zahlreiche Herstellungsverfahren sind zudem sehr zeitaufwändig. Auch werden häufig nur geringe Ausbeuten erzielt und die Reaktionsschritte sind häufig durch eine verminderte Selektivität gekennzeichnet. Auch aufgrund der Verwendung organischer Lösungsmittel bei bekannten Herstellungsverfahren zur Herstellung von Indium-haltigen Präkursoren oder Präkursor-Vorstufen sind die Verfahren zumeist kostenintensiv, wenig umweltfreundlich und gehen zumeist mit Lösungsmittelresten in den Zwischenprodukten und den Endprodukten einher, die wiederum deren Verwendung erheblich einschränken oder eine kostenintensive und aufwändige Aufreinigung erforderlich machen.

DE 37 42 525 A1 betrifft ein Verfahren zur Herstellung von Metallalkylen wie Trimethylindium, wobei eine Herstellung ausgehend von Lithiumtetramethylindat als Präkursor-Vorstufe durch Umsetzung mit Indiumtrichlorid beschrieben ist in einem organischen Lösungsmittel. Es wird ein Gemisch erhalten, das Trimethylindium umfasst und das nachfolgend noch isoliert und gereinigt werden muss. Die Ausbeute ist selbst nach Aufreinigung mit lediglich 82% des theoretischen Wertes angegeben. Auch ist die Herstellung durch eine relativ hohe Verfahrensdauer von mehr als 24 Stunden gekennzeichnet.

EP 0 372 138 A1 beschreibt ein Verfahren zur Herstellung organometallischer Verbindungen, nach dem auch Trialkylindium-Verbindungen erhältlich sind über eine nichtflüchtige Präkursor-Vorstufe, die beispielsweise Lithiumtetramethylindat sein kann. Die Herstellung von Lithiumtetramethylindat aus Indiumtrichlorid findet in Diethylether unter Zusatz von Methyllithium statt, was das Verfahren insgesamt sehr kostenintensiv gestaltet. Das Lithiumtetramethylindat wird mit Indiumtrichlorid zu Trimethylindium umgesetzt, welches nachfolgend noch aufgereinigt werden muss. Angaben zur tatsächlichen Ausbeute finden sich nicht. Außerdem ist das beschriebene Verfahren sehr aufwändig, unter anderem infolge zahlreicher Isolierungs- und Aufreinigungsschritte.

Gynane et. al. beschreiben die Umsetzung von Indium mit Alkylbromiden und Alkyliodiden zu Sesquihalogeniden (Gynane, M. J. S, Waterworth, L. G. und Worrall, I. J., J. Organometal. Chem., 40, 1972). Auch in einer weiteren Veröffentlichung ist die Umsetzung von Indiummonobromid oder Indiummonoiodid mit Alkyliodiden oder Alkylbromiden zu Alkylindiumdihalogeniden beschrieben, wobei sehr lange Reaktionszeiten erforderlich sind (Gynane, M. J. S, Waterworth, L. G. und Worrall, I. J., J. Organometal. Chem., 43, 1972).

US 5,663,390 betrifft die Herstellung von Alkylmetallchloriden durch Umsetzung eines Alkylchlorids mit elementarem Metall in Gegenwart von H₂ als Reaktionsbeschleuniger. Letzteres ist jedoch nachteilig, insbesondere ist das beschriebene Verfahren sehr aufwändig und die Umsetzung erfolgt nur unvollständig. Dabei zielt US 5,663,390 auf die Herstellung von Dimethylindiumchlorid oder Methylindiumdichlorid, abhängig von der Reaktionszeit. Entweder wird reines Dimethylindiumchlorid oder reines Methylindiumdichlorid als Reaktionsprodukt und potentielle Präkursor-Vorstufe erhalten. Die Reaktion ist insgesamt sehr aufwändig und kostenintensiv und eignet sich daher nicht für den industriellen Maßstab. KR101221861B1 offenbart ein Verfahren zur Herstellung von Indium Dialkyl Chlorid durch Umsetzung von Trialkylindium mit Indiumtrichlorid.

### Aufgabe

Es ist eine Aufgabe der vorliegenden Erfindung ein Verfahren bereitzustellen, das eine bedarfsgerechte und kostengünstige Herstellung von geeigneten Präkursor-Vorstufen für Indium-haltige Präkursoren ermöglicht bei einfacher und schneller Prozessführung. Auch soll das Verfahren eine Herstellung solcher Verbindungen mit hoher Ausbeute und hoher Reinheit ermöglichen. Die Präkursor-Vorstufen sollen ferner einfach isolierbar und ausreichend lagerstabil sein.

Weiterhin sollen aus der Vorstufe erhältliche Indium-haltige Präkursoren möglichst frei von Sauerstoffverunreinigungen und in hoher Ausbeute und mit hoher Selektivität und Reinheit ausgehend von der Vorstufe erhältlich sein. Die erhältlichen Indium-haltigen Präkursoren sollen hierdurch besonders für MOCVD-Prozesse geeignet sein, was für die Herstellung von Halbleiterschichten jeweils hochreine Organometallverbindungen erfordert.

Das Verfahren soll zudem wenig umweltbelastend und ressourcenschonend durchführbar sein.

### Lösung

Die Aufgabe der vorliegenden Erfindung wird durch die Gegenstände der Patentansprüche und der nachfolgenden kurzen Beschreibung der Erfindung gelöst.

### Kurze Beschreibung der Erfindung

1. Verfahren zur Herstellung einer Verbindung (A) der allgemeinen Formel:

   **R₂InCl**

   umfassend die Reaktionsschritte
   a1) Reaktion eines Indiumdonors mit einem Alkyldonor zur Bildung der Verbindung (A), wobei der Alkyldonor Alkylaluminiumsesquichlorid (R₃Al₂Cl₃) ist, und wobei der Indiumdonor Indiumtrichlorid (InCl₃) ist,
   a2) und optional Isolierung von Verbindung (A) vom Reaktionsgemisch;
2. wobei R ein Alkylrest mit 1 bis 4 Kohlenstoffatomen ist. Der Alkylrest kann verzweigt oder unverzweigt sein, bevorzugt unverzweigt. Verfahren nach einem der vorangegangenen Punkte, wobei R Methyl oder Ethyl ist.
3. Verfahren nach einem der vorangegangenen Punkte, wobei R Methyl ist.
4. Verfahren nach einem der vorangegangenen Punkte, wobei im Reaktionsschritt a1) ferner eine Hilfsbase zugesetzt wird, wobei die Hilfsbase mindestens ein Halogenid eines Metalls der Gruppen 1, 2, oder 13 (IA, IIA oder IIIA) des Periodensystems umfasst.
5. Verfahren nach Punkt 4, wobei die Hilfsbase Natriumchlorid, Kaliumchlorid, Aluminiumchlorid oder Mischungen daraus umfasst.
6. Verfahren nach Punkt 4, wobei die Hilfsbase eine Mischung von Natriumchlorid und Kaliumchlorid ist, und wobei das Molverhältnis von Natriumchlorid zu Kaliumchlorid zwischen 6:3 und 8:3 beträgt.
7. Verfahren nach Punkt 4 oder 5, wobei die Hilfsbase eine Mischung aus Aluminiumchlorid, Natriumchlorid und Kaliumchlorid ist, und wobei das Molverhältnis von Aluminiumchlorid zu Natriumchlorid zu Kaliumchlorid 45 bis 55 zu 30 bis 40 zu 10 bis 20 beträgt.
8. Verfahren nach einem der Punkte 4 bis 7, wobei 0,8 bis 2,5 Äquivalente Hilfsbase pro Äquivalent Indiumdonor im Reaktionsschritt a1) eingesetzt werden.
9. Verfahren nach wenigstens einem der vorangegangenen Punkte, wobei zwischen 0,6 und 2 Äquivalente Alkyldonor pro Äquivalent Indiumdonor im Reaktionsschritt a1) eingesetzt werden.
10.Verfahren nach wenigstens einem der vorangegangenen Punkte, wobei der Indiumdonor im Reaktionsschritt a1) im Reaktionsgefäß vorgelegt und der Alkyldonor anschließend zugesetzt wird.
11.Verfahren nach Punkt 10, wobei im Reaktionsschritt a1) zunächst eine Mischung umfassend Indiumdonor und eine Hilfsbase vorgelegt wird und zu dieser Mischung anschließend Alkyldonor zugesetzt wird, wobei die Hilfsbase mindestens ein Halogenid eines Metalls der Gruppen 1, 2, oder 13 (IA, IIA oder IIIA) des Periodensystems umfasst.
12.Verfahren nach einem der vorangegangenen Punkte, wobei das Verfahren die Isolierung von Verbindung (A) als Schritt a2) umfasst, und wobei die Isolierung das Abtrennen flüchtiger Bestandteile vom im Reaktionsgefäß befindlichen Reaktionsgemisch und die Sublimation von Verbindung (A) vom Reaktionsgemisch umfasst.
13.Verfahren nach einem der vorangegangenen Punkte, wobei der Reaktionsschritt a1) unter Abwesenheit organischer Lösungsmittel durchgeführt wird.
14.Verfahren nach einem der Punkte 1 bis 13, wobei die Ausbeute an Verbindung (A) wenigstens 79% beträgt.
15.Verfahren nach einem der Punkte 1 bis 14, wobei die Reinheit der Verbindung (A) wenigstens 95% beträgt.
16.Verfahren zur Herstellung von Trialkylindium der Formel **R₃In** umfassend folgende Reaktionsschritte:
   - Herstellen von Dialkylindiumchlorid, Verbindung (A), der Formel **R₂InCl** nach einem der vorangegangenen Punkte;
      b1) Reaktion von Verbindung (A) mit einem Alkyllithium zur Bildung von Lithiumtetraalkylindat (LiInR₄), und Isolierung von LiInR₄ vom Reaktionsgemisch, und
      b2) Reaktion von LiInR₄ mit einer Indiumchlorid-Komponente, wobei eine Verbindung (B) der allgemeinen Formel erhalten wird:

         **R₃In,**

         wobei R wie in Punkt 1 oder 2 definiert ist.
17.Verfahren nach Punkt 16, wobei die Indiumchlorid-Komponente die allgemeine Formel aufweist:

   **RₐIn_{b}Cl_{c}**

   wobei a eine Zahl ausgewählt aus 0, 1, 2 und 3 und b eine Zahl ausgewählt aus 1 und 2 und c eine Zahl ausgewählt aus 1, 2 und 3 ist, und wobei a + b + c = 4 oder ein Vielfaches von 4 ist, und wobei R wie in Punkt 1 oder 2 definiert ist.
18.Verfahren nach einem der Punkte 16 oder 17, wobei die Indiumchlorid-Komponente ausgewählt ist aus R₂InCl, R₃In₂Cl₃, RInCl₂ und InCl₃.
19.Verfahren nach einem der Punkte 16 bis 18, wobei die Ausbeute an Verbindung (B) über 90% beträgt.
20.Verfahren nach einem der Punkte 16 bis 19, wobei die Reinheit der Verbindung (B) wenigstens 99% beträgt.
21.Verfahren nach einem der Punkte 1 bis 15, umfassend folgende zusätzliche Reaktionsschritte:
   c) Reaktion von Verbindung (A) mit einem Alkylierungsmittel zur Bildung von Verbindung (C) mit der allgemeinen Formel:

      **R₂InR'**

      wobei R' ein nukleophiler Rest ist ausgewählt aus der Gruppe bestehend aus verzweigtem, unverzweigtem, substituiertem oder unsubstituiertem Alkyl, substituiertem oder unsubstituiertem Aryl, und wobei R wie oben definiert ist.
22.Verfahren nach Punkt 21, wobei das Alkylierungsmittel ausgewählt ist aus R'MgX, R'Li und R'₃Al.
23.Verfahren nach einem der Punkte 21 oder 22, wobei R Methyl ist, und wobei R' ein Me2N-(CH₂)₃-Rest ist.
24.Verfahren für die metallorganische chemische Gasphasenabscheidung (MOCVD) oder die metallorganische Gasphasenepitaxie (MOVPE) mit den Schritten: - Bereitstellen der Verbindung (B) nach einem Verfahren gemäß einem der Punkte 16 bis 20; - Einsetzen der Verbindung (B) in einem Verfahren für die metallorganische chemische Gasphasenabscheidung (MOCVD) oder die metallorganische Gasphasenepitaxie (MOVPE).
25.Verfahren für die metallorganische chemische Gasphasenabscheidung (MOCVD) oder die metallorganische Gasphasenepitaxie (MOVPE) mit den Schritten: - Bereitstellen der Verbindung (C) nach einem Verfahren gemäß einem der Punkte 21 bis 23; - Einsetzen der Verbindung (C) in einem Verfahren für die metallorganische chemische Gasphasenabscheidung (MOCVD) oder die metallorganische Gasphasenepitaxie (MOVPE).
26. Verfahren nach einem der vorstehenden Punkte 1 bis 15, umfassend folgende zusätzliche Reaktionsschritte:
   b1) Reaktion von Verbindung (A) mit einem Alkyllithium zur Bildung von Lithiumtetraalkylindat (LiInR₄), und Isolierung von LiInR₄ vom Reaktionsgemisch, und
   b2) Reaktion von LiInR₄ mit einer Indiumchlorid-Komponente, wobei eine Verbindung (B) der allgemeinen Formel erhalten wird:

      **R₃In,**
wobei R wie in Punkt 1, 2 oder 3 definiert ist.

### Detaillierte Beschreibung der Erfindung

Die Aufgabe wird insbesondere gelöst durch ein neues Verfahren zur Herstellung von Dialkylindiumchlorid (Verbindung der Formel (A)) mit der allgemeinen Formel:

**R₂InCl,**

wobei R ein niederer Alkylrest ist, also ein solcher mit 1 bis 4 Kohlenstoffatomen. Der Alkylrest kann verzweigt oder unverzweigt sein, bevorzugt unverzweigt. Geeignete Alkylreste sind daher Isopropyl, Cyclopropyl, Isobutyl, sec-Butyl, tert-Butyl, insbesondere aber Propyl, n-Butyl sowie Ethyl oder Methyl.

Das Verfahren ist aufgrund der verwendeten Ausgangssubstanzen und weiterer Reagenzien kostengünstig und wenig umweltbelastend sowie ermöglicht die Herstellung von R₂InCl mit schneller Prozessführung und hoher Ausbeute sowie mit hoher Reinheit. Insbesondere kann erfindungsgemäß weitgehend auf den Einsatz üblicherweise erforderlicher organischer Lösungsmittel verzichtet werden, was zu einer kosteneffektiven und umweltschonenden Verfahrensführung beiträgt. Weiterhin von Vorteil ist, dass Verbindung (A) einfach isolierbar ist. Ebenso ist diese Präkursor-Vorstufe regelmäßig nicht pyrophor und nicht flüchtig und ausreichend lagerstabil.

Das erfindungsgemäße Verfahren eignet sich besonders zur Herstellung von Dimethylindiumchlorid (Me₂InCl) und Diethylindiumchlorid (Et₂InCl), ganz besonders für die Herstellung von Me₂InCl. R ist also vorzugsweise ausgewählt aus Ethyl und Methyl, ganz besonders bevorzugt ist R Methyl.

Erfindungsgemäß wird also zunächst ein neues Verfahren zur Herstellung von R₂InCl, also der Verbindung (A), bereitgestellt. An das erfindungsgemäße Verfahren können sich weitere Reaktionsschritte anschließen, so dass erfindungsgemäß auch Indium-haltige Präkursoren für MOCVD- oder MOVPE-Prozesse kostengünstig und mit schneller Prozessführung sowie in hoher Ausbeute und Reinheit erhältlich sind. Das erfindungsgemäße Verfahren umfasst also die Herstellung von Verbindung (A). In Ausführungsformen können sich an das erfindungsgemäße Verfahren zusätzliche Reaktionsschritte anschließen zur Herstellung von Indium-haltigen Präkursoren.

Erfindungsgemäße Indium-haltige Präkursoren sind vorzugsweise ausgewählt aus Verbindungen der allgemeinen Formel R₃In (Verbindung (B)) und R₂InR' (Verbindung (C).

Dabei sind Indium-haltige Präkursoren der allgemeinen Formel:

**R₃In,**

erfindungsgemäß solche, in denen R ein niederer Alkylrest mit 1 bis 4 Kohlenstoffatomen ist. Der Alkylrest kann verzweigt oder unverzweigt, bevorzugt unverzweigt sein. R ist insbesondere ausgewählt aus Ethyl und Methyl, insbesondere ist R Methyl. Indium-haltige Präkursoren der allgemeinen Formel:

**R₂InR',**

sind erfindungsgemäß solche, in denen R ein niederer Alkylrest mit 1 bis 4 Kohlenstoffatomen ist, der verzweigt oder unverzweigt sein kann, und wobei R' ein nukleophiler Rest ist, der von R verschieden ist. R' ist vorzugsweise ausgewählt aus verzweigtem oder unverzweigtem und substituiertem oder unsubstituiertem Alkyl, verzweigtem oder unverzweigtem und substituiertem oder unsubstituiertem Aryl. R' kann insbesondere mit verzweigten oder unverzweigten Alkyl- oder Alkoxygruppen, oder mit Aminresten substituiertes Phenyl oder Alkyl sein.

Insbesondere handelt es bei sich bei R' um Alkyl- oder Arylreste mit 1 bis 6 Kohlenstoffatomen, welche substituiert sind mit verzweigten oder unverzweigten Alkyl- oder Alkoxygruppen, wie Methyl, Ethyl, n-Butyl, Propyl, sec-Butyl, Tert.-Butyl, Isobutyl, Isopropyl, Cyclopropyl, Cyclobutyl, Methoxy, Ethoxy, n-Butoxy, Propoxy, sec-Butoxy, Tert.-Butoxy, Isobutoxy, Isopropoxy, Cyclopropoxy, Cyclobutoxy; oder aber es handelt sich bei R' um Alkyl- oder Arylreste mit 1 bis 6 Kohlenstoffatomen, die (insbesondere einfach, oder zweifach) substituiert sind mit Aminresten, welche selbst mit verzweigten oder unverzweigten Alkylgruppen, wie Methyl, Ethyl, n-Butyl, Propyl, sec-Butyl, Tert.-Butyl, Isobutyl, Isopropyl, Cyclopropyl, Cyclobutyl, substituiert sind. R' kann beispielsweise Phenyl, Toluyl, Mesityl, Dimethylamino, Diethylamino, Dibutylamino, Diisopropylamino, Et₂N-(CH₂)₃, Me₂N-(CH₂)₂, Me₂N-CH₂, Et₂N-(CH₂)₂, Et₂N-CH₂, Isopropyl, Cyclopropyl, Isobutyl, sec-Butyl, tert-Butyl, Cyclopropyl, insbesondere aber Propyl, n-Butyl sowie Ethyl oder Methyl. Sofern die Definitionen von R und R' gleiche Reste umfassen, so müssen sich in Verbindung (C) R und R' voneinander unterscheiden. Ist also R gleich Methyl, dann muss R' von Methyl verschieden sein.

In einer Ausführungsform der Erfindung ist R Methyl oder Ethyl und R' ist ein Me₂N-(CH₂)₃-Rest. In einer weiteren Ausführungsform der Erfindung ist R Methyl und R' Ethyl. In einer weiteren Ausführungsform der Erfindung ist R Ethyl und R' Methyl. Daher ergeben sich die Verbindungen Me₂lnEt, Et₂InMe sowie Me₂In-(CH₂)₃-N-Me₂ bzw. (CH₃)₂In-(CH₂)₃-N-(CH₃)₂.

In Ausführungsformen schließen sich also weitere Reaktionsschritte an das erfindungsgemäße Verfahren an, so dass auch Indium-haltige Präkursoren, vorzugsweise R₃In (also Verbindung (B)) oder R₂InR' (also Verbindung (C)), kostengünstig und bedarfsgerecht sowie mit schneller Prozessführung erhalten werden können.

Die aus Verbindung (A) bevorzugt erhältlichen Indium-haltigen Präkursoren (B) und (C) sind aufgrund der besonders hohen Reinheit besonders geeignet für die Herstellung von Indium-haltigen Filmen, wie InP-, InAlP- und AlInGaP-Filme, in der Halbleiterindustrie und in der verwandten Elektronikindustrie im Rahmen von MOCVD oder MOVPE-Prozessen.

### 1. Verfahren zur Herstellung von Verbindung (A)

Das erfindungsgemäße Verfahren zur Herstellung von R₂InCl, also Verbindung (A), umfasst die Reaktionsschritte:
a1) Reaktion eines Indiumdonors mit einem Alkyldonor zur Bildung von Verbindung (A), wobei es sich bei dem Indiumdonor um Indiumtrichlorid (InCl₃) und bei dem Alkyldonor um Alkylaluminiumsesquichlorid (R₃Al2Cl₃) handelt, und
a2) optional Isolierung der Verbindung (A).

### Reaktionsschritt a1):

Der Indiumdonor ist erfindungsgemäß eine Verbindung, die Indium umfasst. Es handelt sich bei dem Indiumdonor erfindungsgemäß um InCl₃.

Der Alkyldonor ist erfindungsgemäß eine Verbindung, die eine Alkylgruppe umfasst, wobei es sich beim dem Alkyldonor erfindungsgemäß um ein Alkylchlorid handelt, das also neben der Alkylgruppe auch wenigstens ein Chloratom umfasst. Erfindungsgemäß handelt es sich bei dem Alkyldonor um Alkylaluminiumsesquichlorid (R₃Al₂Cl₃). R₃Al₂Cl₃ ist auch als Mischung von R₂AlCl und RAlCl₂ darstellbar, was erfindungsgemäß mit umfasst ist. Ganz besonders bevorzugt ist der Alkyldonor ausgewählt aus Methylaluminiumsesquichlorid (Me₃Al₂Cl₃) und Ethylaluminiumsesquichlorid (Et₃Al₂Cl₃), weiter bevorzugt ist der Alkyldonor Methylaluminiumsesquichlorid (Me₃Al₂Cl₃).

Bevorzugt werden für diese Reaktion 0,4 bis 5 Äquivalente Alkyldonor pro Äquivalent Indiumdonor eingesetzt. Weiter bevorzugt werden 0,5 bis 4,5 Äquivalente und besonders bevorzugt 0,6 bis 4 Äquivalente Alkyldonor pro Äquivalent Indiumdonor verwendet. Wird der Alkyldonor in einem zu geringen Anteil im Verhältnis zum Indiumdonor eingesetzt, so besteht die Gefahr einer nicht vollständigen Umsetzung und einer verringerten Ausbeute an Verbindung (A). Werden zu hohe Mengen an Alkyldonor im Verhältnis zum Indiumdonor eingesetzt, so wird das Verfahren insgesamt zu teuer und zu unwirtschaftlich und ist im industriellen Maßstab nicht mehr wirtschaftlich durchführbar, was erfindungsgemäß unerwünscht ist.

Als besonders vorteilhaft hat es sich erwiesen, zwischen 0,6 und 2 Äquivalente Alkyldonor pro Äquivalent Indiumdonor einzusetzen, noch weiter bevorzugt zwischen 0,8 und 1,3 Äquivalente Alkyldonor pro Äquivalent Indiumdonor und ganz besonders bevorzugt zwischen 0,9 und 1,1 Äquivalente Alkyldonor pro Äquivalent Indiumdonor. Damit konnten überraschenderweise besonders vorteilhafte Ausbeuten an Verbindung (A) erzielt werden.

Die Reaktion kann unter Anwesenheit einer Hilfsbase stattfinden. Die Hilfsbase umfasst erfindungsgemäß mindestens ein Metallhalogenid. Ein erfindungsgemäß bevorzugtes Metallhalogenid hat die allgemeine Formel:

**MXₙ,**

wobei n die Werte 1, 2 oder 3 annehmen kann, X ausgewählt ist aus Chlor, Brom, Fluor und Iod und M ausgewählt ist aus der Gruppe der IA-Metalle, IIA-Metalle und IIIA-Metalle. Bevorzugte Gruppe IA Metalle sind Kalium, Natrium, Lithium, Rubidium und Cäsium. Bevorzugte Gruppe IIA Metalle sind Magnesium, Calcium, Strontium und Barium. Ein bevorzugtes Gruppe IIIA-Metall ist Aluminium. Vorzugsweise ist M ein Gruppe-IA- und/oder Gruppe IIIA-Metall. Besonders bevorzugt ist M Natrium, Kalium und/oder Aluminium. X ist bevorzugt ausgewählt aus Fluor und Chlor. Weiter bevorzugt ist X Chlor.

Die Verwendung einer Hilfsbase ist vorteilhaft. So kann sich im Verfahren eine eutektische Salzschmelze bilden, die dazu beitragen kann, dass Verbindung (A) mit hoher Selektivität erhalten wird, und dass etwaige Nebenprodukte, wie Alkylindiumdichlorid (RInCl₂), nur in Spuren entstehen.

In bevorzugten Ausführungsformen umfasst die Hilfsbase Natriumchlorid, Kaliumchlorid, Aluminiumchlorid oder Mischungen davon. Insbesondere kann die Hilfsbase eine Mischung aus Natriumchlorid, Kaliumchlorid und Aluminiumchlorid sein.

In einer ganz besonders bevorzugten Ausführungsform ist die Hilfsbase ausgewählt aus Kaliumchlorid, Natriumchlorid und Mischungen davon. Diese Metallhalogenide sind kostengünstig verfügbar und ermöglichen damit eine besonders kosteneffektive Verfahrensführung. Besonders bevorzugt umfasst die Hilfsbase eine Mischung aus Kaliumchlorid und Natriumchlorid. Überraschenderweise zeigte sich, dass eine solche Mischung besonders hohe Ausbeuten an Verbindung (A) ermöglicht. Werden als Hilfsbase nur Natriumchlorid oder nur Kaliumchlorid eingesetzt, also keine Mischung, so kann die Gefahr verringerter Ausbeuten an Verbindung (A) bestehen.

Bevorzugt liegt das Molverhältnis von Natriumchlorid zu Kaliumchlorid in der Hilfsbase zwischen 6:4 und 8:2, weiter bevorzugt zwischen 6:3 und 8:3 und besonders bevorzugt zwischen 6,5:3 und 7,5:3. Überraschenderweise führt die Einhaltung eines solchen Molverhältnisses zu besonders hohen Ausbeuten an Verbindung (A) trotz des hohen Natriumanteils. In einer besonders bevorzugten Ausführungsform liegt das Molverhältnis von Natriumchlorid zu Kaliumchlorid in der Hilfsbase bei 7:3.

In Ausführungsformen, in denen die Hilfsbase eine Mischung aus Aluminiumchlorid, Natriumchlorid und Kaliumchlorid ist, beträgt das Molverhältnis von Aluminiumchlorid zu Natriumchlorid zu Kaliumchlorid bevorzugt 45 bis 55 zu 30 bis 40 zu 10 bis 20, besonders bevorzugt 50 zu 35 zu 15.

Das Verhältnis der eingesetzten Äquivalente der Hilfsbase zur eingesetzten Anzahl an Äquivalenten des Indiumdonors beträgt bevorzugt 0,7:1 bis 2,8:1, weiter bevorzugt 0,8:1 bis 2,5:1. Zu hohe Anteile an Hilfsbase können die Ausbeute durch Nebenreaktionen verringern. In einer besonders bevorzugten Ausführungsform beträgt das Verhältnis der eingesetzten Äquivalente der Hilfsbase zur eingesetzten Anzahl an Äquivalenten des Indiumdonors zwischen 1,8:1 und 2,2:1, noch mehr bevorzugt 2:1. Dies ermöglicht überraschenderweise die Herstellung von Verbindung (A) mit besonders hoher Ausbeute.

Bevorzugt werden die Edukte Indiumdonor und Alkyldonor dem Reaktionsgefäß nacheinander zugesetzt. Besonders bevorzugt wird zunächst eine Mischung umfassend Indiumdonor und optional Hilfsbase vorgelegt und zu dieser Mischung anschließend der Alkyldonor zugesetzt. Dies führt überraschenderweise zu hohen Ausbeuten und vereinfacht zudem den apparativen Aufwand. So kann der Indiumdonor und optional die Hilfsbase in den Reaktor einfach eingewogen werden. Anschließend kann eine kontrollierte Zugabe des Alkyldonors erfolgen.

Die Zugabe des Alkyldonors zur Mischung aus Indiumdonor und optional Hilfsbase kann über einen Tropftrichter oder eine entsprechende industrielle Ausführungsform erfolgen, vorteilhaft unter Rühren des vorgelegten Indiumdonors und der optionalen Hilfsbase. Dies trägt dazu bei, eine ausreichende Vermischung und quantitative Umsetzung sicherzustellen. In alternativen Ausführungsformen wird Alkyldonor und optional Hilfsbase im Reaktionsgefäß vorgelegt und anschließend Indiumdonor zugesetzt.

Optional kann während der Reaktion von Alkyldonor und Indiumdonor zusätzlicher Alkyldonor zugegeben werden. Dies kann vorteilhaft hinsichtlich der Ausbeute an Verbindung (A) sein. Allerdings wird bei der erfindungsgemäßen Verfahrensführung regelmäßig bereits eine ausreichende Ausbeute erzielt ohne Zugabe zusätzlichen Alkyldonors. Erfindungsgemäß bevorzugt erfolgt daher keine Zugabe zusätzlichen Alkyldonors im Reaktionsschritt a1) während der Reaktion.

Die Temperatur während der Zugabe des Alkyldonors liegt bevorzugt unterhalb von 100°C. Besonders bevorzugt wird eine Temperatur von 80°C während der Zugabe des Alkyldonors nicht überschritten, um unerwünschte Nebenreaktionen zu vermeiden. Es kann bei Zugabe des Alkyldonors von außen gekühlt werden. Die Temperatur steigt bei der Zugabe des Alkyldonors vorzugsweise nicht höher als auf 50°C und noch mehr bevorzugt nicht höher als 35°C. Dies ist vorteilhaft, um die Bildung von Nebenprodukten zu vermeiden und aus Sicherheitsgründen sowie wirtschaftlichen Erwägungen.

Nach Zugabe des Alkyldonors kann das Reaktionsgemisch optional aufgeheizt werden. Eine Temperatur von 350°C, insbesondere von 280°C, wird dabei nicht überschritten, um die Gefahr von Nebenreaktionen zu vermindern. Vorteilhaft liegt aber die Temperatur nach Zugabe aller Reaktanden und während der Reaktion im Bereich von Raumtemperatur bis 120°C, also beispielsweise unter 80°C oder unter 50°C oder unter 40°C, in weiteren Ausführungsformen bei unter 35°C, oder bei Raumtemperatur, also 25 +/- 5°C.

Die Zugabe des Alkyldonors erfolgt vorzugsweise bei Normaldruck, also 0,101325 MPa +/- 5%, bis leichtem Überdruck um bis zu 0,02 MPa. Anschließend kann ein Vakuumschritt folgen, bevorzugt wird also anschließend Vakuum angelegt mit einem Restgasdruck von vorzugsweise unter 1 hPa, bevorzugt unter 0,1 hPa und mehr bevorzugt unter 5x10⁻² hPa.

Reaktionsschritt a1) findet bevorzugt unter Schutzgas statt, besonders bevorzugt unter Argon.

Überraschenderweise konnten mit dem erfindungsgemäßen Verfahren auch unter Abwesenheit organischer Lösungsmittel hohe Ausbeuten an Verbindung (A) erzielt werden. Vorzugsweise wird bei der Reaktion des Indiumdonors mit dem Alkyldonor zur Bildung von Verbindung (A) also kein organisches Lösungsmittel eingesetzt. Unter organischen Lösungsmitteln werden erfindungsgemäß kohlenstoffhaltige, flüssige Substanzen verstanden. Unter Abwesenheit eines organischen Lösungsmittels wird erfindungsgemäß verstanden, dass kein organisches Lösungsmittel zusätzlich als Reaktionsmedium eingesetzt wird. Dies hat den Vorteil, dass mögliche organische Verunreinigungen in der Verbindung (A) durch partielle Zersetzung des Lösungsmittels vermieden werden. Darüber hinaus kann das Verfahren hierdurch umweltschonender durchgeführt werden. Außerdem konnte bei Abwesenheit organischer Lösungsmittel im Schritt a1) überraschenderweise eine besonders hohe Selektivität der Reaktion verzeichnet werden.

Die Reaktionszeit des Schritts a1) beträgt vorzugsweise zwischen 30 min und 30 Stunden. Eine Reaktionszeit zwischen 30 min und 28 Stunden, insbesondere zwischen 2,5 Stunden und 25 Stunden hat sich als besonders vorteilhaft in Bezug auf die Ausbeute an Verbindung (A) erwiesen. Gute Ergebnisse sind mit Reaktionstemperaturen im Bereich von etwa 90°C bis etwa 120°C, aber auch bei Temperaturen unter 35°C, oder bei Raumtemperatur, also 25 +/- 5°C, erzielt werden.

Eine Reaktionszeit im Schritt a1) von 3 bis 8 Stunden, vorzugsweise 4 bis 7 Stunden kann bereits ausreichend sein.

In einer besonders bevorzugten Ausführungsform des erfindungsgemäßen Verfahrens läuft im Reaktionsschritt a1) schematisch folgende Reaktion ab:

3 InCl₃ + 2 Me₃Al₂Cl₃ + 4 Na/KCl → 3 **Me₂InCl** + 4 Na/KAlCl₄

### Reaktionsschritt a2):

Die erfindungsgemäß optionale Isolierung der Verbindung (A) umfasst vorzugsweise das Abtrennen flüchtiger Bestandteile vom im Reaktionsgefäß befindlichen Reaktionsgemisch und/oder Verfahrensschritte ausgewählt aus der Sublimation der Verbindung (A) vom Reaktionsgemisch und dem mechanischem Entfernen von Verbindung (A) aus dem Reaktionsgefäß. Besonders bevorzugt umfasst die Isolierung von Verbindung (A) das Abtrennen flüchtiger Bestandteile vom im Reaktionsgefäß befindlichen Reaktionsgemisch und die Sublimation von Verbindung (A) vom Reaktionsgemisch.

Der Begriff "Isolierung" beziehungsweise "Isolieren" umfasst dabei erfindungsgemäß das Abtrennen des jeweiligen gewünschten Reaktionsproduktes vom im Reaktionsgefäß befindlichen Reaktionsgemisch durch Entfernen des Reaktionsproduktes aus dem Reaktionsgefäß oder das Entfernen sonstiger Verbindungen neben dem Reaktionsprodukt vom Reaktionsgemisch derart, dass das Reaktionsprodukt im Reaktionsgefäß zurückbleibt.

Die Sublimation der Verbindung (A) erfolgt vorzugsweise durch Erhitzen des Reaktionsgemisches auf Temperaturen von bis zu 250°C, weiter bevorzugt bis zu 220°C und besonders bevorzugt bis zu 200°C. Die Temperaturen, auf die zur Sublimation der Verbindung (A) erhitzt wird, betragen vorzugsweise wenigstens 90°C und bevorzugt wenigstens 95°C sowie weiter bevorzugt wenigstens 100°C. Bevorzugt wird die Temperatur für wenigstens 20 min, weiter bevorzugt wenigstens 40 min und besonders bevorzugt wenigstens 60 min beibehalten zur ausreichenden Sublimation der Verbindung (A). Bei der Sublimation der Verbindung (A) kann ein Vakuum angelegt werden, insbesondere mit einem Restgasdruck von unter 0,1 hPa oder von unter 5x10⁻² hPa. Die Sublimation der Verbindung (A) ist aber auch bei Normaldruck bei Temperaturen im Bereich von 150°C bis 200°C möglich.

Es hat sich als besonders vorteilhaft für die Reinheit der Verbindung (A) erwiesen, zunächst flüchtige Nebenprodukte durch Anlegen eines Vakuums mit einem Restgasdruck unter 0,1 hPa, bevorzugt unter 5x10⁻² hPa zu entfernen, und erst nachfolgend die Verbindung (A) zu sublimieren. Optional können sich an das Isolieren der Verbindung (A) weitere Reinigungsschritte der Verbindung (A) anschließen, wobei dem Fachmann geeignete Verfahren zu Aufreinigung chemischer Stoffe bekannt sind. Erfindungsgemäß bevorzugt wird durch die besondere Verfahrensführung und Edukte aber auch ohne weitere Reinigungsschritte bereits eine ausreichend hohe Reinheit der Verbindung (A) erzielt. Erfindungsgemäß bevorzugt sind daher neben der Isolierung von Verbindung (A) keine weiteren Reinigungsschritte von Verbindung (A) mehr erforderlich.

In alternativen Ausführungsformen erfolgt keine Isolierung von Verbindung (A) aus dem Reaktionsgemisch. In solchen Ausführungsformen wird das Reaktionsgemisch umfassend Verbindung (A) und optional die Hilfsbase beziehungsweise die bei Verwendung einer Hilfsbase resultierende Salzschmelze direkt zur Herstellung von Indium-haltigen Präkursoren, insbesondere Verbindung (B) oder (C), verwendet. In diesen Ausführungsformen schließen sich also zusätzliche Reaktionsschritte zur Herstellung von vorzugsweise Verbindung (B) oder (C) unmittelbar an Reaktionsschritt a1) an ohne eine Isolierung der Verbindung (A) vom Reaktionsgemisch, also ohne den Reaktionsschritt a2). Dies ermöglicht eine noch schnelle Prozessführung bei der Herstellung Indium-haltiger Präkursoren.

Das erfindungsgemäße Verfahren ermöglicht die Herstellung von Verbindung (A) mit einer Ausbeute von vorzugsweise wenigstens 70%, weiter bevorzugt wenigstens 75%, noch weiter bevorzugt wenigstens 79% und ganz besonders bevorzugt von wenigstens 85% sowie noch weiter bevorzugt über 90% und noch mehr bevorzugt über 95%. Erfindungsgemäße Angaben zur Ausbeute sind stets auf die theoretische Ausbeute bezogen.

Die Reinheit der erfindungsgemäß hergestellten Verbindung (A) beträgt vorzugsweise wenigstens 95%, bevorzugt wenigstens 98% und besonders bevorzugt mehr als 99%. Es sind also vorzugsweise nicht mehr als 5%, bevorzugt nicht mehr als 2% und weiter bevorzugt unter 1% Verunreinigungen, also unerwünschte Substanzen, in der hergestellten Verbindung (A) enthalten.

Eine bevorzugte Verbindung (A), die nach dem erfindungsgemäßen Verfahren erhältlich ist, ist ausgewählt aus Dimethylindiumchlorid (Me₂InCl) und Diethylindiumchlorid (Et₂InCl). Ganz besonders eignet sich das erfindungsgemäße Verfahren zur Herstellung von Me₂InCl.

### 2. Weiterverarbeitung der Verbindung (A) zu Indium-haltigen Präkursoren

Die nach dem oben beschriebenen Verfahren erhaltene Verbindung (A) kann optional weiterverarbeitet werden zu Indium-haltigen Präkursoren, erfindungsgemäß bevorzugt ausgewählt aus den Verbindungen (B) und (C). Erfindungsgemäß ist daher auch die Verwendung der nach dem erfindungsgemäßen Verfahren hergestellten Verbindung (A) zur Herstellung von Indium-haltigen Präkursoren, bevorzugt ausgewählt aus Verbindung (B) und (C), für MOCVD- oder MOVPE-Prozesse.

Besonders geeignet ist die erfindungsgemäß hergestellte Verbindung (A) zur Herstellung von Indium-haltigen Präkursoren der allgemeinen Formel:

**R₃In**,

also Verbindung (B), wobei R ein niederer Alkylrest mit 1 bis 4 Kohlenstoffatomen ist. Der Alkylrest kann verzweigt oder unverzweigt sein, bevorzugt unverzweigt. R ist vorzugsweise ausgewählt aus Ethyl und Methyl, insbesondere ist R Methyl.

Alternativ kann die erfindungsgemäß hergestellte Verbindung (A) zur Herstellung Indium-haltiger Präkursoren der allgemeinen Formel:

**R₂InR',**

also Verbindung (C), verwendet werden, wobei R ein niederer Alkylrest mit 1 bis 4 Kohlenstoffatomen ist, der verzweigt oder unverzweigt sein kann, und wobei R' ein nukleophiler Rest ist, der von R verschieden ist.

R' ist vorzugsweise ausgewählt aus verzweigtem oder unverzweigtem und substituiertem oder unsubstituiertem Alkyl, verzweigtem oder unverzweigtem und substituiertem oder unsubstituiertem Aryl. R' kann insbesondere mit verzweigten oder unverzweigten Alkyl- oder Alkoxygruppen, oder mit Aminresten substituiertes Phenyl oder Alkyl sein.

Insbesondere handelt es bei sich bei R' um Alkyl- oder Arylreste mit 1 bis 6 Kohlenstoffatomen, welche substituiert sind mit verzweigten oder unverzweigten Alkyl- oder Alkoxygruppen, wie Methyl, Ethyl, n-Butyl, Propyl, sec-Butyl, Tert.-Butyl, Isobutyl, Isopropyl, Cyclopropyl, Cyclobutyl, Methoxy, Ethoxy, n-Butoxy, Propoxy, sec-Butoxy, Tert.-Butoxy, Isobutoxy, Isopropoxy, Cyclopropoxy, Cyclobutoxy; oder aber es handelt sich bei R' um Alkyl- oder Arylreste mit 1 bis 6 Kohlenstoffatomen, die (insbesondere einfach, oder zweifach) substituiert sind mit Aminresten, welche selbst mit verzweigten oder unverzweigten Alkylgruppen, wie Methyl, Ethyl, n-Butyl, Propyl, sec-Butyl, Tert.-Butyl, Isobutyl, Isopropyl, Cyclopropyl, Cyclobutyl, substituiert sind. R' kann beispielsweise Phenyl, Toluyl, Mesityl, Dimethylamino, Diethylamino, Dibutylamino, Diisopropylamino, Et₂N-(CH₂)₃, Me₂N-(CH₂)₂, Me₂N-CH₂, Et₂N-(CH₂)₂, Et₂N-CH₂, Isopropyl, Cyclopropyl, Isobutyl, sec-Butyl, tert-Butyl, Cyclopropyl, insbesondere aber Propyl, n-Butyl sowie Ethyl oder Methyl. Sofern die Definitionen von R und R' gleiche Reste umfassen, so müssen sich in Verbindung (C) R und R' voneinander unterscheiden. Ist also R gleich Methyl, dann muss R' von Methyl verschieden sein.

In einer Ausführungsform der Erfindung ist R Methyl oder Ethyl und R' ist ein Me₂N-(CH₂)₃-Rest. In einer weiteren Ausführungsform der Erfindung ist R Methyl und R' Ethyl. In einer weiteren Ausführungsform der Erfindung ist R Ethyl und R' Methyl. Daher ergeben sich die Verbindungen Me₂InEt, Et₂InMe sowie Me₂In-(CH₂)₃-N-Me₂ bzw. (CH₃)₂In-(CH₂)₃-N-(CH₃)₂.

### 2.1. Weiterverarbeitung der Verbindung (A) zu Verbindung (B)

In bevorzugten Ausführungsformen schließen sich an die Herstellung der Verbindung (A) zusätzlich folgende weitere Reaktionsschritte an, wobei die Verbindung (B) erhältlich ist:
b1) Reaktion von Verbindung (A) mit einem Alkyllithium zur Bildung von Lithiumtetraalkylindat, und Isolierung von LiInR₄ vom Reaktionsgemisch, und
b2) Reaktion des LiInR₄ mit einer Indiumchlorid-Komponente, wobei Verbindung (B) erhalten wird.

Reaktionsschritt b2) kann sich unmittelbar an Reaktionsschritt b1) anschließen. Alternativ kann Reaktionsschritt b2) auch zeitlich versetzt zu Reaktionsschritt b1) erfolgen.

### Reaktionsschritt b1):

Reaktionsschritt b1) umfasst die Reaktion von Verbindung (A) mit einem Alkyllithium zur Bildung von Lithiumtetraalkylindat, wobei das Lithiumtetraalkylindat folgender allgemeiner Formel genügt:

**LiInR₄**

wobei R wie oben definiert ist. R ist vorzugsweise Methyl oder Ethyl, noch mehr bevorzugt Methyl.

Der Begriff "Alkyllithium" umfasst solche Verbindungen, die wenigstens eine Alkylgruppe und Lithium umfassen. Das Alkyllithium weist erfindungsgemäß bevorzugt folgende allgemeine Formel auf:

**RLi**

wobei R wie oben definiert ist. Ganz besonders bevorzugt ist das Alkyllithium ausgewählt aus Ethyllithium (EtLi) und Methyllithium (MeLi), weiter bevorzugt ist das Alkyllithium MeLi. Auf diese Weise lassen sich auch Verbindungen der Formel (C), R₂InR', erhalten, wenn ein Alkyllithium der Formel R'Li verwendet wird, wobei R' von R verschieden und wie oben definiert ist. Ansonsten handelt es sich bei RLi und R'Li um die gleiche Stoffklasse.

Als Alkylierungsmittel wird im Reaktionsschritt b1) erfindungsgemäß Alkyllithium eingesetzt. Dem Fachmann sind weitere Alkylierungsmittel bekannt, die für Alkylierungsreaktionen verwendet werden können. Weitere metallorganische Alkylierungsmittel sind bekannt und können organische Verbindungen von Metallen der Gruppen 1, 2, 12 und 13 umfassen, also beispielsweise von Alkali- und Erdalkalimetallen. Gut geeignet sind insbesondere Lithium, Magnesium und Natrium, aber auch Elemente wie Zink und Aluminium. Dem Fachmann bekannte Alkylierungsmittel umfassen insbesondere Dimethylzink oder Trimethylaluminium.

Als organische Lösungsmittel für Schritt b1) eignen sich insbesondere Dialkylether. Ganz besonders bevorzugt wird ein Lösungsmittel ausgewählt aus Diethylether, längerkettigen Ethern und Mischungen daraus im Reaktionsschritt b1) verwendet, wobei längerkettige Ether solche sind, die Alkylgruppen mit mehr als 2 C-Atomen umfassen. Noch mehr bevorzugt ist das Lösungsmittel Diethylether oder Di-n-butylether, weiter bevorzugt Diethylether.

Bevorzugt werden im Reaktionsschritt b1) 1 bis 5,6 Äquivalente Alkyllithium pro Äquivalent an Verbindung (A) eingesetzt, besonders bevorzugt 1,2 bis 5,4 Äquivalente Alkyllithium pro Äquivalent Verbindung (A). Es hat sich als besonders vorteilhaft erwiesen, nicht zu viel Alkyllithium einzusetzen. Damit ist das Verfahren insgesamt noch kosteneffektiver durchführbar und es konnte eine hohe Reinheit und Ausbeute an LiInR₄ erzielt werden. Insbesondere sollten nicht mehr als 6 Äquivalente Alkyllithium pro Äquivalent R₂InCl, also Verbindung (A) eingesetzt werden, damit das Verfahren kosteneffektiv durchführbar ist und etwaige Verunreinigungen durch Alkyllithium im LiInR₄ vermindert beziehungsweise verhindert werden. Es sollte aber auch nicht zu wenig Alkyllithium bezogen auf Verbindung (A) eingesetzt werden, sonst erfolgt eine unzureichende Umsetzung und die Ausbeute an LiInR₄ kann verringert sein. Es hat sich als besonders vorteilhaft erwiesen, zwischen 1,3 und 3 Äquivalente Alkyllithium pro Äquivalent R₂InCl einzusetzen, besonders bevorzugt zwischen 1,5 und 2,5 Äquivalente und noch mehr bevorzugt zwischen 1,8 und 2,2 Äquivalente sowie ganz besonders bevorzugt etwa 2 Äquivalente.

In bevorzugten Ausführungsformen wird das Alkyllithium in dem organischen Lösungsmittel vorgelegt und Verbindung (A) anschließend zugesetzt, bevorzugt bei Temperaturen zwischen -10 und 10°C, weiter bevorzugt bei Temperaturen zwischen -5 und 5°C, weiter bevorzugt bei -2 bis 2°C und noch mehr bevorzugt bei 0 +/- 1°C. Die Reaktion findet vorzugsweise bei Temperaturen zwischen -30°C und dem Siedepunkt des organischen Lösungsmittels statt, weiter bevorzugt bei -5°C bis 35°C.

In alternativen Ausführungsformen wird Verbindung (A) in dem organischen Lösungsmittel vorgelegt und nachfolgend das Alkyllithium zugesetzt. Dabei wird das Alkyllithium als Mischung mit dem organischen Lösungsmittel bevorzugt zugetropft, besonders bevorzugt bei Temperaturen zwischen -5 und 5°C, weiter bevorzugt bei -2 bis 2°C.

Vorzugsweise wird nach Zugabe aller Reaktanden gerührt für bevorzugt wenigstens 10 min, weiter bevorzugt wenigstens 15 min. Die Reaktionszeit beträgt in der Regel nicht mehr als 48 Stunden, bevorzugt nicht mehr als 24 Stunden.

LiInR₄ wird isoliert vom Reaktionsgemisch. Dies erfolgt vorzugsweise durch Entfernen des Lösungsmittels und etwaiger Nebenprodukte, insbesondere LiCI, oder Rückstände der Reaktanden, vorzugsweise durch Abdestillieren flüchtiger Bestandteile und/oder Filtration des Reaktionsgemischs. Ein Isolieren des LiInR₄ durch Filtration und anschließende Destillation des Lösungsmittels hat sich als besonders vorteilhaft erwiesen. Es können sich weitere Reinigungsschritte anschließen nach dem Fachmann bekannten Verfahren zur Aufreinigung chemischer Substanzen.

In einer bevorzugten Ausführungsform läuft im Reaktionsschritt b1) schematisch folgende Reaktion ab:

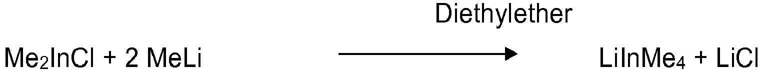

### Reaktionsschritt b2):

Aus LiInR₄ ist Verbindung (B) durch Reaktion von LiInR₄ mit einer Indiumchlorid-Komponente herstellbar.

Die "Indiumchlorid-Komponente" ist erfindungsgemäß eine Verbindung, die Indium und Chlorid umfasst. Der Begriff "Indiumchlorid-Komponente" umfasst insbesondere auch Verbindungen, die neben Indium und Chlorid auch wenigstens einen Alkylrest umfassen. Die Indiumchlorid-Komponente hat vorzugsweise folgende allgemeine Formel:

**RₐIn_{b}Cl_{c},**

wobei a eine Zahl ausgewählt aus 0, 1, 2 und 3 ist und b eine Zahl ausgewählt aus 1 und 2 ist und c eine Zahl ausgewählt aus 1, 2 und 3 ist, und wobei a + b + c = 4 oder ein Vielfaches von 4 sind, besonders bevorzugt ist die Summe aus a, b und c = 4 oder 8. R ist wie oben definiert.

Ganz besonders bevorzugt ist die Indiumchlorid-Komponente ausgewählt aus InCl₃, R₂InCl, R₃In₂Cl₃, RInCl₂ und Mischungen davon. Ganz besonders bevorzugte Indiumchlorid-Komponenten sind R₂InCl oder R₃In₂Cl₃, insbesondere Me₂InCl, Et₂InCl, Me₃In₂Cl₃ oder Et₃In₂Cl₃, weiter bevorzugt Me₂InCl oder Me₃In₂Cl₃. Es kann also erfindungsgemäß auch Verbindung (A) als Indiumchlorid-Komponente eingesetzt werden, was das erfindungsgemäße Verfahren noch kostengünstiger gestaltet. In besonders bevorzugten Ausführungsformen ist die Indiumchlorid-Komponente daher R₂InCl.

Das Molverhältnis von Lithiumtetraalkylindat zu der Indiumchlorid-Komponente kann zwischen 1:1 bis 3:1 betragen, bevorzugt etwa 1:1, 2:1 oder 3:1. In Ausführungsformen, in denen die Indiumchlorid-Komponente R₂InCl ist, hat sich ein Molverhältnis von Lithiumtetraalkylindat zu der Indiumchlorid-Komponente von etwa 1:1 als besonders vorteilhaft erwiesen. In Ausführungsformen, in denen die Indiumchlorid-Komponente R₃In₂Cl₃ ist, ist ein Molverhältnis von Lithiumtetraalkylindat zu der Indiumchlorid-Komponente von etwa 3:1 besonders vorteilhaft. In Ausführungsformen, in denen die Indiumchlorid-Komponente RInCl₂ ist, ist ein Molverhältnis von Lithiumtetraalkylindat zu der Indiumchlorid-Komponente von etwa 2:1 besonders vorteilhaft.

Die Reaktion von Lithiumtetraalkylindat mit der Indiumchlorid-Komponente kann in einem organischen Lösungsmittel erfolgen. Geeignete organische Lösungsmittel für Schritt b2) sind ausgewählt aus Alkanen einschließlich von cyclischen gesättigten Kohlenwasserstoffen, Aromaten, Alkoholen, Ethern und cyclischen Ethern. Als organische Lösungsmittel für Schritt b2) haben sich insbesondere Alkane und Aromaten als geeignet erwiesen, bevorzugt ausgewählt aus n-Pentan, Cyclohexan, n-Decan, n-Heptan, n-Hexan, Methylcyclohexan, n-Nonan, n-Octan und Benzol, ganz besonders bevorzugt ist n-Pentan.

In alternativen Ausführungsformen wird kein organisches Lösungsmittel im Reaktionsschritt b2) verwendet, also kein organisches Lösungsmittel zusätzlich als Reaktionsmedium eingesetzt. Dies hat den Vorteil, dass mögliche, die Anwendbarkeit einschränkende organische Verunreinigungen in Verbindung (B) durch partielle Zersetzung des Lösungsmittels vermieden werden. Darüber hinaus kann das Verfahren hierdurch umweltschonender durchgeführt werden. In einer Ausführungsform wird Schritt b2) daher unter Abwesenheit organischer Lösungsmittel durchgeführt.

Vorzugsweise wird das LiInR₄ mit der Indiumchlorid-Komponente und optional der Hilfsbase vorgelegt. Anschließend kann das organische Lösungsmittel zugesetzt werden. Vorzugsweise wird anschließend erhitzt, bevorzugt auf Temperaturen zwischen 30°C und 120°C, weiter bevorzugt auf Temperaturen zwischen 40°C und 100°C und noch mehr bevorzugt auf Temperaturen zwischen 50°C und 90°C. Vorzugsweise wird eine solche Temperatur für wenigstens 10 min und höchstens 24 Stunden, bevorzugt für wenigstens 30 min und höchstens 20 Stunden, weiter bevorzugt wenigstens 40 min und höchstens 12 Stunden und noch mehr bevorzugt für wenigstens 90 min und höchstens 3 Stunden aufrechterhalten.

Vorzugsweise wird anschließend abgekühlt, bevorzugt auf eine Temperatur von 25 +/- 5 °C.

Bevorzugt wird Verbindung (B) anschließend vom Gemisch isoliert. Das Isolieren von Verbindung (B) umfasst bevorzugt das Entfernen des organischen Lösungsmittels und von Verbindung (B) vom Reaktionsgemisch, das LiCI umfassen kann. Dies erfolgt insbesondere durch Umkondensieren von organischem Lösungsmittel und Verbindung (B) in ein neues Gefäß. Anschließend wird das Lösungsmittel von Verbindung (B) abgetrennt, bevorzugt durch Abdestillieren im Vakuum mit vorzugsweise einem Restgasdruck unter 0,1 hPa, weiter bevorzugt höchstens 0,01 hPa, vorzugsweise in eine Kühlfalle bei bevorzugt -10° +/- 5°C. Verbindung (B) bleibt vorzugsweise im Gefäß zurück. Optional können sich weitere Reinigungsschritte anschließen nach dem Fachmann bekannten Aufreinigungsverfahren. Besonders bevorzugt umfassen die weiteren Reinigungsschritte die Sublimation von Verbindung (B).

In einer bevorzugten Ausführungsform läuft im Reaktionsschritt b2) schematisch folgende Reaktion ab:

LiInMe₄ + Me₂InCl → 2 Me₃ln + LiCl

In einer alternativen Ausführungsform läuft im Reaktionsschritt b2) schematisch folgende Reaktion ab:

3 LiInMe₄ + 5 Me₃In₂Cl₃ → 5 Me₃ln + 3 LiCl

Die zusätzlichen Reaktionsschritte umfassend b1) und b2) ermöglichen die Herstellung von Verbindung (B) aus Verbindung (A) mit einer Ausbeute von vorzugsweise wenigstens 60%, weiter bevorzugt wenigstens 70%, noch weiter bevorzugt wenigstens 75% und ganz besonders bevorzugt von 85% sowie noch weiter bevorzugt über 90%. Die Reinheit der erfindungsgemäß hergestellten Verbindung (B) beträgt vorzugsweise wenigstens 99%, bevorzugt wenigstens 99,5% und besonders bevorzugt mehr als 99,8% sowie weiter bevorzugt mehr als 99,999%. Insbesondere bei Durchführung eines weiteren Reinigungsschrittes der hergestellten Verbindung (B), vorzugsweise durch Sublimation von Verbindung (B), kann eine Reinheit von > 99,999% erreicht werden.

### 2.2. Weiterverarbeitung der Verbindung (A) zu Verbindung (C)

In alternativen Ausführungsformen wird Verbindung (A) weiterverarbeitet zu Verbindung (C), indem zusätzliche weitere Reaktionsschritte an das erfindungsgemäße Verfahren angeschlossen werden, umfassend:
c) Reaktion von Verbindung (A) mit einem Alkylierungsmittel-zur Bildung von Verbindung (C).

Die Verbindung (C) ist wie oben beschrieben eine Verbindung der allgemeinen Formel R₂InR', wobei R und R' die oben beschriebenen Bedeutungen haben.

Besonders bevorzugt handelt es sich bei Verbindung (C) um Dimethylaminopropyldimethylindium (DADI),Dimethylethylindium oder Diethylmethylindium.

Das Alkylierungsmittel im Schritt c) ist insbesondere ausgewählt aus R'MgX, R'Li und R'₃Al. Besonders bevorzugt ist das Alkylierungsmittel Me₂N-(CH₂)₃-M, wobei M insbesondere MgCl oder Li ist.

Die Umsetzung von Verbindung (A) zu R₂InR', beispielsweise DADI, kann in einem organischen Lösungsmittel erfolgen durch Reaktion mit dem Alkylierungsmittel, beispielsweise Me₂N-(CH₂)₃-M im Falle von DADI. Das organische Lösungsmittel kann ein Dialkylether oder ein cyclischer Ether sein oder Mischungen daraus, insbesondere Dioxan, Diethylether, Dibutylether, tert.-Butylethylether (ETBE), 2-Methoxy-2-methylpropan (Methyl-tert.-Butylether, MTBE) oder Tetrahydrofuran. Auch aliphatische oder aromatische Kohlenwasserstoffe, insbesondere aliiphatische oder aromatische Kohlenwasserstoffe mit fünf bis neun Kohlenstoffatomen, die linear oder cyclisch sein können, und deren Mischungen sind als Lösungsmittel geeignet, wie zum Beispiel n-Pentan, Isopentan, Neopentan, Cyclopentan, Methylcyclopentan, n-Hexan, 2-Methylpentan, 3-Methylpentan, 2,2-Dimethylbutan, 2,3-Dimethylbutan, Cyclohexan, Methylcyclohexan, Heptan, Oktan, Petrolether oder Toluol. Gute Ergebnisse lassen sich insbesondere mit Tetrahydrofuran (THF), Diethylether, Pentan oder auch Cyclohexan erzielen.

Reaktionsschritt c) erfolgt üblicherweise unter Schutzgas.

In einer Ausführungsform der Erfindung wird das Alkylierungsmittel vorgelegt und anschließend Verbindung (A) zugegeben. In einer alternativen Ausführungsform kann auch die Verbindung (A) vorgelegt und anschließend das Alkylierungsmittel zugegeben werden. Sowohl Verbindung (A) als auch das Alkylierungsmittel, können vorteilhaft in einem Lösungsmittel gelöst eingesetzt werden. Dieses Vorgehen liefert insbesondere bei der Verwendung von Alkyllithium oder Alkylmagnesiumhalogeniden (R'Li, R'MgX) gute Ergebnisse. R'₃Al kann auch ohne Lösungsmittel eingesetzt werden.

Dann wird -je nach Ausführungsform - entweder die Lösung der Verbindung (A) oder das Alkylierungsmittel, gegebenenfalls als Lösung, zugetropft.

Dabei kann Verbindung (A) als Mischung mit einem der oben erwähnten Lösungsmittel, vorteilhaft aber insbesondere als Mischung mit einer Kombination dieser organischen Lösungsmittel, insbesondere in Mischung mit Tetrahydrofuran (THF), Diethylether, Pentan und deren Kombinationen, zugetropft werden.

Das Zutropfen von Verbindung (A) erfolgt vorzugsweise langsam, bevorzugt über wenigstens 10 min, weiter bevorzugt über wenigstens 20 min. Die Zugabe von Verbindung (A) erfolgt bevorzugt bei einer Temperatur unter 50°C, weiter bevorzugt unter 40°C und besonders bevorzugt bei Raumtemperatur, also 25°C +/-5°C.

Nach Zugabe aller Reaktanden, insbesondere Alkylierungsmittel und Verbindung (A), erfolgt die Reaktion, die unter Rühren durchgeführt werden kann. Bevorzugt liegt die Temperatur während der Reaktion () bei weniger als 50°C, weiter bevorzugt unter 40°C und besonders bevorzugt bei Raumtemperatur, also 25°C +/- 5°C. Es wird vorzugsweise für wenigstens 5 Stunden, weiter bevorzugt für wenigstens 10 Stunden gerührt. Aus Kostengründen werden Reaktionszeiten von 80 Stunden, weiter bevorzugt 50 Stunden meist nicht überschritten.

Anschließend wird Verbindung (C) vorzugsweise vom Reaktionsgemisch isoliert. Das Isolieren von Verbindung (C) kann das Entfernen des organischen Lösungsmittels, bevorzugt im Vakuum, und die Abtrennung von Verbindung (B) vom Reaktionsgemisch durch Filtration und/oder Destillation umfassen.

Die Alkylierungsmittel können mit bekannten Verfahren hergestellt werden, beispielsweise Me₂N-(CH₂)₃-M aus 3-Chlor-1-(dimethylamino)propan durch Umsetzung mit Magnesiumspänen oder Lithiumspänen. Üblicherweise erfolgt die Herstellung von Me₂N-(CH₂)₃-M in einem organischen Lösungsmittel, insbesondere THF, unter Wärmezufuhr. Gegebenenfalls kann dabei Iod zur Aktivierung zugesetzt werden.

Durch die Einhaltung der Bedingungen des oben dargestellten erfindungsgemäßen Herstellverfahrens zur Herstellung von Verbindung (A) sowie optional der Weiterverarbeitung zu Indium-haltigen Präkursoren, bevorzugt ausgewählt aus Verbindung (B) und (C), können diese Verbindungen in hoher Ausbeute und mit hoher Reinheit hergestellt werden. Erfindungsgemäß ist zudem die nach dem Verfahren herstellgestellte Verbindung (A), insbesondere Me₂InCl, und die daraus erhältlichen Indium-haltigen Präkursoren, insbesondere Trimethylindium, Dimethylaminopropyldimethylindium und Dimethylethylindium.

Insbesondere die hohe Ausbeute und Reinheit sowie kosteneffiziente und wenig umweltbelastende Prozesswahl des erfindungsgemäßen Verfahrens prädestiniert das Verfahren zur industriellen Herstellung von Verbindung (A) beziehungsweise Indium-haltigen Präkursoren. Insbesondere entstehen erfindungsgemäß keine pyrophoren Zwischenprodukte, was im Lichte einer kosteneffektiven und gering aufwändigen Herstellung besonders vorteilhaft ist. Das erfindungsgemäße Verfahren ist insbesondere durch eine besonders hohe Indium-Ausnutzung gekennzeichnet. Der Indium-Gesamtumsatz des erfindungsgemäßen Verfahrens bezogen auf den eingesetzten Indiumdonor beträgt vorzugsweise ≥ 70%, weiter bevorzugt ≥ 75%, besonders bevorzugt ≥ 80% und noch mehr bevorzugt > 95%. Der Gehalt an Sauerstoff in der optional erhältlichen Verbindung (B) oder (C) einschließlich von Indiumperoxiden und -oxiden liegt vorzugsweise bei < 100 ppm (m/m), insbesondere sogar bei < 1 ppm (m/m).

Die mit dem erfindungsgemäßen Verfahren optional herstellbaren Indium-haltigen Präkursoren, insbesondere Trimethylindium und Dimethylaminopropyldimethylindium, eignen sich aufgrund der hervorragenden Reinheit, insbesondere des sehr niedrigen Sauerstoffgehaltes, besonders für MOCVD- oder MOVPE-Prozesse, beispielsweise zur Herstellung von Halbleitern oder Halbleiter-Bauelementen. Die schlussendlich hergestellten Halbleiter oder Halbleiter-Bauelemente sind vielseitig industriell einsetzbar. Erfindungsgemäß ist daher auch das Verfahren für die metallorganische chemische Gasphasenabscheidung (MOCVD) oder die metallorganische Gasphasenepitaxie (MOVPE) mit den Schritten: - Bereitstellen der Verbindung (B) und/oder (C) - Einsetzen der Verbindung (B) und/oder (C) in einem Verfahren für die metallorganische chemische Gasphasenabscheidung (MOCVD) oder die metallorganische Gasphasenepitaxie (MOVPE).

### Ausführungsbeispiele

Es wurde Me₂InCl nach dem erfindungsgemäßen Verfahren hergestellt. Aus Verbindung (A) wurden ferner Me₃ln als Verbindung (B) oder Dimethylaminopropyldimethylindium als Verbindung (C) hergestellt.

### 1. Herstellung von Me₂InCl

### 1.1. Reaktion von Indiumtrichlorid mit Methylaluminiumsesquichlorid zur Bildung von Me₂InCl (Äquivalente Hilfsbase zu Äquivalente Indiumdonor 2:1)

In einem 100 mL Dreihalskolben mit kurzem Liebigkühler und zwei PTFE-Ventilen wurden unter Argon 10 g (45,2 mmol) InCl₃, 3,70 g (63,3 mmol, 1,4 Äquiv. bez. auf InCl₃) NaCl und 2,02 g (27,1 mmol, 0,6 Äquiv.) KCl vorgelegt und gut durchmischt. Über einen Tropftrichter wurden unter Argon 9,29 g (45,2 mmol, 1 Äquiv.) Me₃Al₂Cl₃ zur Salzmischung zugetropft. Die Reaktion verlief schwach exotherm, wobei eine Temperatur von 30°C nicht überschritten wurde. Nach vollständiger Zugabe wurde das entstandene Reaktionsgemisch 20 Stunden über Nacht gerührt. Dabei dickte das Gemisch zu einer nahezu unrührbaren Masse ein. Anschließend wurde bei Raumtemperatur Hochvakuum (1x10⁻² bis 1x10⁻³ hPa) an die Apparatur angelegt und für 0,5 Stunden restliche flüchtige Methylaluminiumverbindungen in einen mit flüssigem Stickstoff gekühlten Schlenkkolben destilliert. Nach Beendigung der Destillation wurde der Kühler auf 30°C gekühlt und das Reaktionsgemisch für zwei Stunden auf 120°C erhitzt. Dabei sublimierte Me₂InCl aus dem Reaktionsgemisch. Es konnten 7,99 g (44,3 mmol) Me₂InCl (identifiziert durch NMR) gewonnen werden. Dies entspricht einer Ausbeute von 98,3%.

### 1.2. Reaktion von Indiumtrichlorid mit Methylaluminiumsesquichlorid zur Bildung von Me₂InCl (Äquivalente Hilfsbase zu Äquivalente Indiumdonor 1:1)

In einem 100 mL Dreihalskolben mit kurzem Liebigkühler und zwei PTFE-Ventilen wurden unter Argon 10 g (45,2 mmol) InCl₃, 1.85 g (31,6 mmol, 0,7 Äquiv. bez. auf InCl₃) NaCl und 1,02 g (13,6 mmol, 0,3 Äquiv.) KCl vorgelegt und gut durchmischt. Über einen Tropftrichter wurden unter Argon 9,26 g (45,2 mmol, 1 Äquiv.) Me₃Al₂Cl₃ zur Salzmischung zugetropft. Die Reaktion verlief schwach exotherm. Nach vollständiger Zugabe wurde das entstandene Reaktionsgemisch 20 Stunden über Nacht gerührt. Dabei dickte das Gemisch zu einer nahezu unrührbaren Masse ein. Anschließend wurde bei Raumtemperatur Hochvakuum (10⁻² bis 10⁻³ hPa) an die Apparatur angelegt und für eine Stunde restliche flüchtige Methylaluminiumverbindungen in einen mit flüssigem Stickstoff gekühlten Schlenkkolben destilliert. Nach Beendigung der Destillation wurde der Kühler auf 30°C gekühlt und das Reaktionsgemisch für drei Stunden auf 120°C erhitzt. Dabei sublimierte das gewünschte Produkt aus dem Reaktionsgemisch. Es konnten 6,46 g (35,9 mmol) Me₂InCl (identifiziert durch NMR) gewonnen werden. Dies entspricht einer Ausbeute von 79.5%.

### 1.3. Reaktion von Indiumtrichlorid mit Methylaluminiumsesquichlorid zur Bildung von Me₂InCl (Äquivalente Hilfsbase zu Äquivalente Indiumdonor 2:1)

In einem 100 mL Dreihalskolben mit kurzem Liebigkühler und zwei PTFE-Ventilen wurden unter Argon 10 g (45.2 mmol) InCl₃ und 5.29 g (90.4 mmol, 2 Äquiv.) NaCl vorgelegt und gut durchmischt. Über einen Tropftrichter wurden unter Argon 9.26 g (45.2 mmol, 1 Äquiv.) Me₃Al₂Cl₃ zur Salzmischung zugetropft. Die Reaktion verlief schwach exotherm. Nach vollständiger Zugabe wurde das entstandene Reaktionsgemisch 20 Stunden über Nacht gerührt, dabei dickte das Gemisch zu einer nahezu unrührbaren Masse ein. Anschließend wurde bei Raumtemperatur Hochvakuum (10⁻² bis 10⁻³ mbar) an die Apparatur angelegt und für 1,5 Stunden restliche flüchtige Methylaluminiumverbindungen in einen mit flüssigem Stickstoff gekühlten Schlenkkolben destilliert. Nach Beendigung der Destillation wurde der Kühler auf 30°C gekühlt und das Reaktionsgemisch für 1,5 Stunden auf 120°C erhitzt, dabei sublimierte das gewünschte Produkt aus dem Reaktionsgemisch. Es konnten 6.27 g (34.8 mmol) Me₂InCl (identifiziert durch NMR) gewonnen werden. Dies entspricht einer Ausbeute von 76.9%.

### 1.4 Reaktion von Indiumtrichlorid mit Methylaluminiumsesquichlorid zur Bildung von Me2InCl (Äquivalente Hilfsbase zu Äquivalente Indiumdonor 2.3:1; in situ Herstellung von Methylaluminiumsesquichlorid)

1.22 g (45.2 mmol, 2 Äquiv.) Aluminium, 15.90 g (119.3 mmol, 5.3 Äquiv.) Aluminiumtrichlorid und 7.15 g (113 mmol, 5 Äquiv.) Na/KCl wurden in einem Schlenckolben, ausgestattet mit einem Sublimationsfinger, vorgelegt und das Reaktionsgemisch auf 130 °C erhitzt, bis sich eine klare Schmelze über dem Aluminium gebildet hatte. Anschließend wurde das Reaktionsgemisch auf 80 °C heruntergekühlt und bei dieser Temperatur unter Normaldruck Chlormethan in das Reaktionsgemisch eingeleitet. Insgesamt wurde das Einleiten von Chlormethan für 16 Stunden unter Rühren bei 80 °C aufrechterhalten.

Anschließend wurden 5.0 g (22.6 mmol) Indiumtrichlorid, sowie 3.29 g (52 mmol, 2.3 Äquiv.) Na/KCl zugegeben. Danach wurde das System langsam auf 150-160 °C hochgeheizt. Ab ca. 150 °C konnte die Resublimation eines farblosen Feststoffes am Sublimationsfinger beobachtet werden. Es wurden 2.56 g (14.2 mmol, Ausbeute: 63%) Me₂InCl, identifiziert über ¹H-NMR, in grobkristalliner Form erhalten.

### 2. Weiterverarbeitung von Me₂InCl zu Me₃In

### 2.1. Reaktion von Me₂InCl mit Alkyllithium zur Bildung von LiInMe₄

1441 mg Me₂InCl (7,8 mmol) aus Beispiel 1.1 wurden bei 0°C zu 10 mL einer MeLi-Lösung (1,565 mol/L in Diethylether) gegeben. Die Suspension wurde über Nacht bei Raumtemperatur gerührt und filtriert. Das klare Filtrat wurde vom Lösungsmittel befreit und es wurden 1079 mg eines farblosen Feststoffes isoliert (entspricht 5,9 mmol LiInMe₄, 76%).

### 2.2. Reaktion von LiInMe₄ mit Me₂InCl zur Bildung von Me₃In

1079 mg LiInMe₄ (5,9 mmol, aus Beispiel 2.1) und 1067 mg Me₂InCl (5,9 mmol) wurden in einer 125 mL Parr-Bombe vorgelegt und mit 20 mL Pentan versetzt. Anschließend wurde die Parr-Bombe in ein auf 70°C vorgeheiztes Ölbad getaucht und über Nacht bei dieser Temperatur gerührt. Bei 70°C war eine leicht trübe Suspension auszumachen, die beim Abkühlen auf Raumtemperatur zu einem Kristallbrei erstarrte. Die flüchtigen Bestandteile der Parr-Bombe wurden in eine Kühlfalle umkondensiert (RT → -78 °C) und anschließend das Lösungsmittel Pentan bei -8°C (Kochsalz-Eis-Mischung) im Feinvakuum entfernt. Es konnten 1591 mg eines farblosen Feststoffes isoliert werden (10.0 mmol, Ausbeute: 81% Trimethylindium).

### 3. Weiterverarbeitung von Me₂InCl zu Dimethylaminopropyldimethylindium (DADI)

### 3.1. Reaktion von Me₂InCl mit Dimethylaminopropylmagnesiumchlorid

In einem 500 mL-Dreihalskolben wurden 75 mL getrocknetes THF und 4,04 g (166.4 mmol, 3 Äquiv.) Magnesium-Späne vorgelegt und auf Rückfluss erhitzt. Nach Zugabe einer Spatelspitze Iod zur Aktivierung des Magnesiums wurden 10.12 g (83.2 mmol, 1.5 Äquiv.) 3-Dimethylaminopropylchlorid langsam zugetropft und anschließend das Reaktionsgemisch für 2.5 h weiter unter Rückfluss erhitzt. Nach Abkühlen des Reaktionsgemisches auf Raumtemperatur wurden 10.00 g (55.4 mmol) Me₂InCl aus Beispiel 1.1 gelöst in 75 mL getrocknetem THF innerhalb von 30 Minuten zugetropft und die entstehende Reaktionslösung 20 Stunden bei Raumtemperatur gerührt.

Anschließend wurde das THF im Vakuum entfernt, der Rückstand in 100 mL getrocknetem Pentan suspendiert, 2 h bei Raumtemperatur gerührt, der entstandene weiße Feststoff über eine Umkehrfritte abgetrennt und zweimal mit je 50 mL getrocknetem Pentan gewaschen. Das klare Filtrat wurde im Vakuum zur Trockne eingeengt und zur Reinigung bei 80°C destilliert. Es wurde DADI als klare Flüssigkeit erhalten. Ausbeute: 7,67 g (36,0 mmol), entspricht 65%.

### 3.2. Reaktion von Me₂InCl mit 3-Dimethylaminopropyllithium

In einem 500 mL-Dreihalskolben wurden 75 mL getrocknetes THF und 1.16 g (170 mmol, 3 Äquiv.) Lithium-Späne vorgelegt und auf Rückfluss erhitzt.
Nach Erreichen des Rückflusses wurden 10.12 g (83.2 mmol, 1.5 Äquiv.) 3-Dimethylaminopropylchlorid langsam zugetropft und anschließend das Reaktionsgemisch für 2.5 h weiter unter Rückfluss erhitzt. Nach Abkühlen des Reaktionsgemisches auf Raumtemperatur wurden 10.00 g (55.4 mmol) Me₂InCl aus Beispiel 1.2 gelöst in 75 mL getrocknetem THF innerhalb von 30 Minuten zugetropft und die entstehende Reaktionslösung 20 Stunden bei Raumtemperatur gerührt.

Anschließend wurde das THF im Vakuum entfernt, der Rückstand in 100 mL getrocknetem Pentan suspendiert, 2 h bei Raumtemperatur gerührt, der entstandene weiße Feststoff über eine Umkehrfritte abgetrennt und zweimal mit je 50 mL getrocknetem Pentan gewaschen. Das klare Filtrat wurde im Vakuum zur Trockne eingeengt und zur Reinigung bei 80°C destilliert. Es wurde DADI als klare Flüssigkeit erhalten, Ausbeute: 7,7 g (36.6 mmol), entspricht 66%.

## Patentansprüche

1. Verfahren zur Herstellung einer Verbindung (A) der allgemeinen Formel:
**R₂InCl**
umfassend die Reaktionsschritte
a1) Reaktion eines Indiumdonors mit einem Alkyldonor zur Bildung der Verbindung (A), wobei der Alkyldonor Alkylaluminiumsesquichlorid (R₃Al2Cl₃) ist, und wobei der Indiumdonor Indiumtrichlorid (InCl₃) ist,
a2) und optional Isolierung von Verbindung (A) vom Reaktionsgemisch;
wobei R ein Alkylrest mit 1 bis 4 Kohlenstoffatomen ist, und wobei R verzweigt oder unverzweigt ist.

2. Verfahren nach einem der vorangegangenen Ansprüche, wobei R Methyl oder Ethyl ist.

3. Verfahren nach einem der vorangegangenen Ansprüche, wobei im Reaktionsschritt a1) ferner eine Hilfsbase zugesetzt wird, wobei die Hilfsbase mindestens ein Halogenid eines Metalls der Gruppen 1, 2, oder 13 (IA, IIA oder IIIA) des Periodensystems umfasst.

4. Verfahren nach Anspruch 3, wobei die Hilfsbase Natriumchlorid, Kaliumchlorid, Aluminiumchlorid oder Mischungen daraus umfasst.

5. Verfahren nach Anspruch 3, wobei die Hilfsbase eine Mischung von Natriumchlorid und Kaliumchlorid ist, und wobei das Molverhältnis von Natriumchlorid zu Kaliumchlorid zwischen 6:3 und 8:3 beträgt.

6. Verfahren nach Anspruch 3 oder 4, wobei die Hilfsbase eine Mischung aus Aluminiumchlorid, Natriumchlorid und Kaliumchlorid ist, und wobei das Molverhältnis von Aluminiumchlorid zu Natriumchlorid zu Kaliumchlorid 45 bis 55 zu 30 bis 40 zu 10 bis 20 beträgt.

7. Verfahren nach einem der Ansprüche 3 bis 6, wobei 0,8 bis 2,5 Äquivalente Hilfsbase pro Äquivalent Indiumdonor im Reaktionsschritt a1) eingesetzt werden.

8. Verfahren nach wenigstens einem der vorangegangenen Ansprüche, wobei zwischen 0,6 und 2 Äquivalente Alkyldonor pro Äquivalent Indiumdonor im Reaktionsschritt a1) eingesetzt werden.

9. Verfahren nach einem der vorangegangenen Ansprüche, wobei das Verfahren die Isolierung von Verbindung (A) als Schritt a2) umfasst, und wobei die Isolierung das Abtrennen flüchtiger Bestandteile vom im Reaktionsgefäß befindlichen Reaktionsgemisch und die Sublimation von Verbindung (A) vom Reaktionsgemisch umfasst.

10. Verfahren zur Herstellung von Trialkylindium der Formel **R₃In** umfassend folgende Reaktionsschritte:
- Herstellen von Dialkylindiumchlorid, Verbindung (A), der Formel **R₂InCl** gemäß den Ansprüchen 1 bis 9;
b1) Reaktion von Verbindung (A) mit einem Alkyllithium zur Bildung von Lithiumtetraalkylindat (LiInR₄), und Isolierung von LiInR₄ vom Reaktionsgemisch, und
b2) Reaktion von LiInR₄ mit einer Indiumchlorid-Komponente, wobei eine Verbindung (B) der allgemeinen Formel erhalten wird:
**R₃In**,
wobei R wie in Anspruch 1 oder 2 definiert ist.

11. Verfahren nach Anspruch 10, wobei die Indiumchlorid-Komponente die allgemeine Formel aufweist:
**RₐIn_{b}Cl_{c}**
wobei a eine Zahl ausgewählt aus 0, 1, 2 und 3 und b eine Zahl ausgewählt aus 1 und 2 und c eine Zahl ausgewählt aus 1, 2 und 3 ist, und wobei a + b + c = 4 oder ein Vielfaches von 4 ist, und wobei R wie in Anspruch 1 oder 2 definiert ist.

12. Verfahren nach einem der Ansprüche 10 oder 11, wobei die Indiumchlorid-Komponente ausgewählt ist aus R₂InCl, R₃In₂Cl₃, RInCl₂ und InCl₃.

13. Verfahren nach einem der Ansprüche 1 bis 9, umfassend folgende zusätzliche Reaktionsschritte:
c) Reaktion von Verbindung (A) mit einem Alkylierungsmittel zur Bildung von Verbindung (C) mit der allgemeinen Formel:
**R₂InR'**
wobei R' ein nukleophiler Rest ist ausgewählt aus der Gruppe bestehend aus verzweigtem, unverzweigtem, substituiertem oder unsubstituiertem Alkyl, substituiertem oder unsubstituiertem Aryl, und wobei R wie in Anspruch 1 oder 2 definiert ist.

14. Verfahren nach Anspruch 13, wobei das Alkylierungsmittel ausgewählt ist aus R'MgX, R'Li und R'₃Al.

15. Verfahren nach einem der Ansprüche 13 oder 14, wobei R Methyl ist, und wobei R' ein Me₂N-(CH₂)₃-Rest ist.

16. Verfahren für die metallorganische chemische Gasphasenabscheidung (MOCVD) oder die metallorganische Gasphasenepitaxie (MOVPE) mit den Schritten: - Bereitstellen der Verbindung (B) nach einem Verfahren gemäß einem der Ansprüche 10 bis 12; - Einsetzen der Verbindung (B) in einem Verfahren für die metallorganische chemische Gasphasenabscheidung (MOCVD) oder die metallorganische Gasphasenepitaxie (MOVPE).

17. Verfahren für die metallorganische chemische Gasphasenabscheidung (MOCVD) oder die metallorganische Gasphasenepitaxie (MOVPE) mit den Schritten: - Bereitstellen der Verbindung (C) nach einem Verfahren gemäß einem der Ansprüche 13 bis 15; - Einsetzen der Verbindung (C) in einem Verfahren für die metallorganische chemische Gasphasenabscheidung (MOCVD) oder die metallorganische Gasphasenepitaxie (MOVPE).

## Claims

1. Method for producing a compound (A) having the general formula:
**R₂InCl**
comprising the reaction steps of
a1) reacting an indium donor with an alkyl donor to form the compound (A), wherein the alkyl donor is alkylaluminum sesquichloride (R₃Al₂Cl₃), and wherein the indium donor is indium trichloride (InCl₃),
a2) and optionally isolating compound (A) from the reaction mixture;
wherein R is an alkyl radical having 1 to 4 carbon atoms, and wherein R is branched or unbranched.

2. Method according to one of the preceding claims, wherein R is methyl or ethyl.

3. Method according to one of the preceding claims, wherein, in the reaction step a1), an auxiliary base is additionally added, wherein the auxiliary base comprises at least one halide of a metal of the groups 1, 2, or 13 (IA, IIA, or IIIA) of the periodic table.

4. Method according to claim 3, wherein the auxiliary base comprises sodium chloride, potassium chloride, aluminum chloride, or mixtures thereof.

5. Method according to claim 3, wherein the auxiliary base is a mixture of sodium chloride and potassium chloride, and wherein the molar ratio of sodium chloride to potassium chloride is between 6:3 and 8:3.

6. Method according to claim 3 or 4, wherein the auxiliary base is a mixture of aluminum chloride, sodium chloride, and potassium chloride, and wherein the molar ratio of aluminum chloride to sodium chloride to potassium chloride is 45-55 to 30-40 to 10-20.

7. Method according to one of claims 3 through 6, wherein 0.8 to 2.5 equivalents of auxiliary base per equivalent of indium donor are used in reaction step a1).

8. Method according to at least one of the preceding claims, wherein between 0.6 and 2 equivalents of alkyl donor per equivalent of indium donor are used in reaction step a1).

9. Method according to one of the preceding claims, wherein the method comprises the isolation of compound (A) as step a2), and wherein the isolation comprises the separation of volatile components from the reaction mixture located in the reaction vessel and the sublimation of compound (A) from the reaction mixture.

10. Method for the preparation of trialkylindium of the formula **R₃In**, comprising the following reaction steps:
- preparation of dialkylindium chloride, compound (A), of the formula **R₂InCl** according to claims 1 through 9;
b1) reacting compound (A) with an alkyl lithium to form lithium tetraalkylindate (LiInR₄), and isolating LiInR₄ from the reaction mixture, and
b2) reacting LiInR₄ with an indium chloride component, wherein a compound (B) is obtained having the general formula:
**R₃In**,
wherein R is defined as in claim 1 or 2.

11. Method according to claim 10, wherein the indium chloride component has the general formula:
**RₐIn_{b}Cl_{c}**
wherein a is a number selected from 0, 1, 2, and 3, and b is a number selected from 1 and 2, and c is a number selected from 1, 2, and 3, and wherein a + b + c = 4 or a multiple of 4, and wherein R is defined as in claim 1 or 2.

12. Method according to one of claims 10 or 11, wherein the indium component is selected from R₂InCl, R₃In₂Cl₃, RInCl₂, and InCl₃.

13. Method according to one of claims 1 through 9, comprising the following additional reaction steps:
c) reaction of compound (A) with an alkylating agent to form compound (C) having the general formula:
**R₂InR'**
wherein R' is a nucleophilic radical selected from the group made up of branched, unbranched, substituted or unsubstituted alkyl, substituted or unsubstituted aryl, and wherein R is defined as in claim 1 or 2.

14. Method according to claim 13, wherein the alkylating agent is selected from R'MgX, R'Li, and R'₃Al.

15. Method according to one of claims 13 or 14, wherein R is methyl, and wherein R' is a Me₂N-(CH₂)₃ radical.

16. Method for metalorganic chemical vapor deposition (MOCVD) or metalorganic vapor phase epitaxy (MOVPE), comprising the steps of: - providing the compound (B) according to a method as per one of claims 10 through 12; - employing the compound (B) in a method for metalorganic chemical vapor deposition (MOCVD) or metalorganic vapor phase epitaxy (MOVPE).

17. Method for metalorganic chemical vapor deposition (MOCVD) or metalorganic vapor phase epitaxy (MOVPE), comprising the steps of: - providing the compound (C) according to a method as per one of claims 13 through 15; - employing the compound (C) in a method for metalorganic chemical vapor deposition (MOCVD) or metalorganic vapor phase epitaxy (MOVPE).

## Revendications

1. Procédé de préparation d'un composé (A) de formule générale :
**R₂InCl**
comprenant les étapes de réaction de
a1) réaction d'un donneur d'indium avec un donneur d'alkyle pour former le composé (A), le donneur d'alkyle étant le sesquichlorure d'alkylaluminium (R₃Al2Cl₃) et le donneur d'indium étant le trichlorure d'indium (InCl₃),
a2) et isolement facultatif du composé (A) à partir du mélange réactionnel ;
R représentant un radical alkyle comprenant 1 à 4 atomes de carbone et R étant ramifié ou non ramifié.

2. Procédé selon une des revendications précédentes, R représentant méthyle ou éthyle.

3. Procédé selon une des revendications précédentes, une base auxiliaire étant en outre ajoutée dans l'étape de réaction a1), la base auxiliaire comprenant au moins un halogénure d'un métal des groupes 1, 2 ou 13 (IA, IIA ou IIIA) du tableau périodique.

4. Procédé selon la revendication 3, la base auxiliaire comprenant du chlorure de sodium, du chlorure de potassium, du chlorure d'aluminium ou des mélanges de ceux-ci.

5. Procédé selon la revendication 3, la base auxiliaire étant un mélange de chlorure de sodium et de chlorure de potassium et le rapport molaire de chlorure de sodium à chlorure de potassium étant situé entre 6:3 et 8:3.

6. Procédé selon la revendication 3 ou 4, la base auxiliaire étant un mélange de chlorure d'aluminium, de chlorure de sodium et de chlorure de potassium, le rapport molaire de chlorure d'aluminium à chlorure de sodium à chlorure de potassium étant de 45-55:30-40:10-20.

7. Procédé selon une des revendications 3 à 6, 0,8 à 2,5 équivalents de base auxiliaire par équivalent de donneur d'indium étant utilisés dans l'étape de réaction a1).

8. Procédé selon au moins une des revendications précédentes, 0,6 à 2 équivalents de donneur d'alkyle par équivalent de donneur d'indium étant utilisés dans l'étape de réaction a1).

9. Procédé selon une des revendications précédentes, le procédé comprenant l'isolement du composé (A) comme étape a2) et l'isolement comprenant la séparation de composants volatils à partir du mélange réactionnel se trouvant dans le récipient de réaction et la sublimation du composé (A) à partir du mélange réactionnel.

10. Procédé pour la préparation de trialkylindium de formule **R₃In** comprenant les étapes de réaction suivantes :
- préparation de chlorure de dialkylindium, composé (A), de formule **R₂InCl** selon les revendications 1 à 9 ;
b1) réaction du composé (A) avec un alkyllithium pour former le tétra-alkylindate de lithium (LiInR₄) et isolement du LiInR₄ à partir du mélange réactionnel et
b2) réaction du LiInR₄ avec un composant de chlorure d'indium, un composé (B) de formule générale étant obtenu :
**R₃In**,
R étant défini comme dans la revendication 1 ou 2.

11. Procédé selon la revendication 10, le composant de chlorure d'indium présentant la formule générale :
**RₐIn_{b}Cl_{c}**
dans laquelle a représente un nombre choisi parmi 0, 1, 2 et 3 et b représente un nombre choisi parmi 1 et 2 et c représente un nombre choisi parmi 1, 2 et 3 et dans laquelle a + b + c = 4 ou un multiple de 4 et dans laquelle R est défini comme dans la revendication 1 ou 2.

12. Procédé selon une des revendications 10 ou 11, le composant de chlorure d'indium étant choisi parmi R₂InCl, R₃In₂Cl₃, RInCl₂ et InCl₃.

13. Procédé selon une des revendications 1 à 9, comprenant les étapes de réaction suivantes :
c) réaction du composé (A) avec un agent d'alkylation pour former le composé (C) de formule générale :
**R₂InR'**
dans laquelle R' représente un radical nucléophile choisi dans le groupe constitué par alkyle ramifié, non ramifié, substitué ou non substitué, aryle substitué ou non substitué et dans laquelle R est défini comme dans la revendication 1 ou 2.

14. Procédé selon la revendication 13, l'agent d'alkylation étant choisi parmi R'MgX, R'Li et R'₃Al.

15. Procédé selon une des revendications 13 ou 14, R représentant méthyle et R' représentant un radical Me₂N-(CH₂)₃

16. Procédé pour le dépôt chimique métallo-organique en phase gazeuse (MOCVD) ou l'épitaxie métallo-organique en phase gazeuse (MOVPE) présentant les étapes de : - préparation du composé (B) selon un procédé selon une des revendications 10 à 12 ; - utilisation du composé (B) dans un procédé pour le dépôt chimique métallo-organique en phase gazeuse (MOCVD) ou l'épitaxie métallo-organique en phase gazeuse (MOVPE).

17. Procédé pour le dépôt chimique métallo-organique en phase gazeuse (MOCVD) ou l'épitaxie métallo-organique en phase gazeuse (MOVPE) présentant les étapes de : - préparation du composé (C) selon un procédé selon une des revendications 13 à 15 ; - utilisation du composé (C) dans un procédé pour le dépôt chimique métallo-organique en phase gazeuse (MOCVD) ou l'épitaxie métallo-organique en phase gazeuse (MOVPE).
